# EUROPEAN PATENT SPECIFICATION

(11) **EP 1 739 844 B1**
(45) Date of publication and mention of the grant of the patent: **12.12.2012**
(21) Application number: 06113463.1
(22) Date of filing: 03.05.2006
(51) Int. Cl.: H04B 1/036, H04B 1/38

(54) **Portable electronic apparatus**
Tragbares elektronisches Gerät
Appareil électronique portable

(30) Priority: 27.06.2005 CN 200510081011
(43) Date of publication of application: 03.01.2007
(73) Proprietor: HTC Corporation, Taoyuan County 330 (TW)
(72) Inventor: Huang, Yi-Chang, Xindian City (TW); Lin, Yao-Chung, Xindian City (TW)
(74) Representative: 2K Patentanwälte Blasberg Kewitz & Reichel

(56) References cited:
- EP-A- 1 233 666
- EP-A- 1 533 840
- EP-A- 1 545 097
- US-A1- 2004 132 503

## Description

### BACKGROUND

The invention relates to a portable electronic apparatus, and more particularly to a portable electronic apparatus with a heat-dissipation function.

When a portable electronic apparatus (for example, a personal digital assistant or a cell phone) performs wireless network communication or other high energy-consumptive operations, heat produced by chips moves to light-emitting elements, batteries or other electronic elements thereof via a circuit board, and raising the temperature thereof. This damages electronic elements and shortens lifespan. Additionally, battery charging chips produce high temperatures during the battery charging and such high temperatures may explode batteries (particularly lithium battery).

US 2004/132503 relates to a thermal management method and apparatus for the heat-producing microelectronic package(s) contained within an enclosure also comprising a battery. In one embodiment in accordance with the present invention, the heat-producing microelectronic package(s) contained within a wireless phone enclosure is placed in thermal communication with the battery. The battery is therefore utilized as a thermal mass that absorbs and dissipates the heat during operation. The battery is provided to re-conduct the thermal energy back to the microelectronic package and to the thermally conductive circuit substrate for dissipation. In another embodiment, the battery is provided to conduct the thermal energy to a thermal conductive enclosure exterior side.

EP 1 545 097 relates to a case for a mobile terminal which allows for improved dissipation of heat generated by internal components. The improved case includes a first cover coupled to a second cover with a space formed therebetween to accommodate a heat generating portion of the mobile terminal. A heat discharging member is coupled to the second cover to discharge heat generated by the heat generating portion of the mobile terminal. In this manner, heat generated by internal components of the mobile terminal is effectively discharged, thus preventing product damage due to excessive heat, and enhancing system functionality and user convenience.

EP 1 233 666 relates to a communication device and, more particularly, to a heat radiating structure for dissipating heat from a pyrogenic element enclosed within a housing. The conventional communication device has a problem in that it is difficult to efficiently lower the temperature of a heat generating element mounted on a printed substrate and also to lower a surface temperature of a housing. The communication device of this invention is intended to solve the above discussed problem and is of a type including a communication circuit mounted on a printed substrate (2) and having a heat generating element (1); a shield casing (3) covering the communication circuit and shielding electromagnetic waves; a housing (4) for accommodating the shield casing (3) and the printed substrate (2); a heat diffusing member (5) mounted along an inner wall of the shield casing (3) for diffusing heat in a planar direction; and a heat insulating layer (6) disposed between the shield casing (3) and an inner wall of the housing (4).

EP 1 533 840 relates to a system and method for transferring heat within a terminal for a mobile communication system. The system comprises a circuit board (52) mounted to a terminal body (10), in which a heat generating component (50) is mounted, and a shield frame (56) for shielding electromagnetic waves generated from the circuit board and supporting the circuit board. At least one heat radiating apparatus (62,70,72,80,82,84) is installed between the heat generating component and the shield frame. The at least one heat radiating apparatus transfers heat generated by the heat generating component away from the circuit board and substantially directly to the shield frame. The heat transfer prevents an impact of the generated heat being transferred to the circuit board from the shield frame.

### SUMMARY

An embodiment of a portable electronic apparatus comprises a housing, a circuit board, a heat-conduction structure and a heat-dissipation structure. The circuit board is disposed in the housing and comprises a substrate and a first electronic device, wherein the first electronic device is disposed on the substrate. The heat-conduction structure is disposed on the circuit board, and dissipates heat from the first electronic device. The heat-dissipation structure is disposed on the housing and connected to the heat-conduction structure, wherein the heat passes the heat-conduction structure and the heat-dissipation structure, and is dissipated out of the housing.

The invention reduces inner temperature of the portable electronic apparatus, increases the lifespan of chips and light-emitting elements thereof, and prevents the battery from exploding.

### DESCRIPTION OF THE DRAWINGS

The invention will be more fully understood from the following detailed description and the accompanying drawings, given by the way of illustration only and thus not intended to limit the invention.
Fig. 1a is an exploded view of a portable electronic apparatus of a first embodiment;
Fig. 1b shows the partially assembled portable electronic apparatus;
Fig. 1c shows the completely assembled portable electronic apparatus;
Fig. 2a is a bottom view of a heat-conduction structure of the first embodiment;
Fig. 2b is a sectional view of a circuit board and the heat-conduction structure of the first embodiment;
Fig. 2c shows heat dissipated out of the portable electronic apparatus of the first embodiment;
Fig. 3a shows a portable electronic apparatus of a second embodiment;
Fig. 3b is a sectional view of a circuit board and a heat-conduction structure of the second embodiment;
Fig. 3c shows heat dissipated out of the portable electronic apparatus of the second embodiment.

### DETAILED DESCRIPTION

### First embodiment

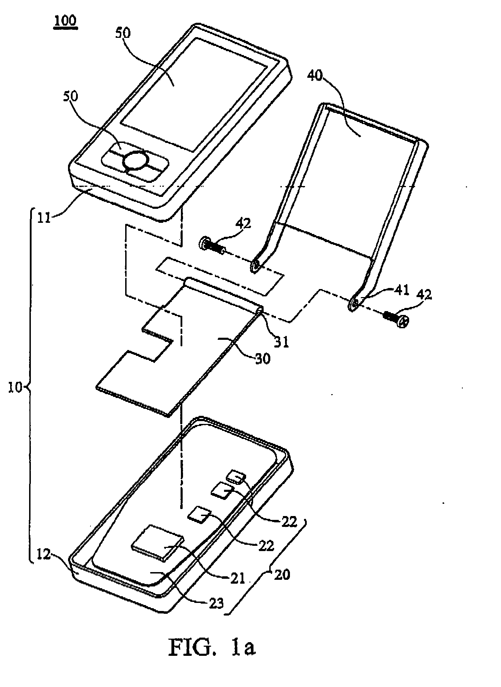

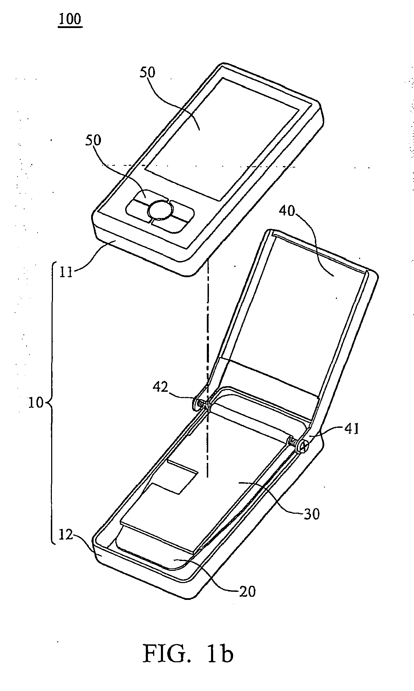

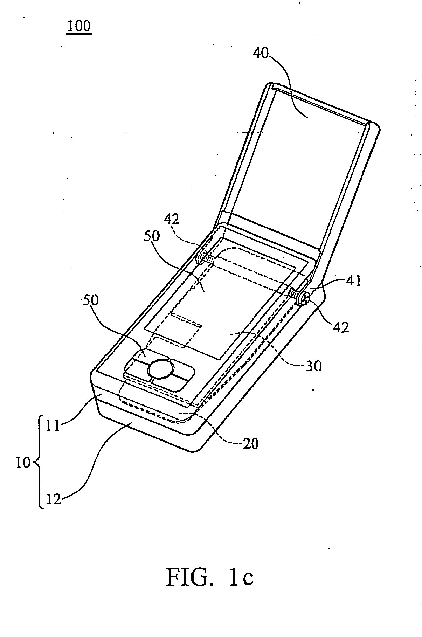

Fig. 1a is an exploded view of a portable electronic apparatus 100 of the invention, which comprises a housing 10, a circuit board 20, a heat-conduction structure 30, a heat-dissipation structure 40 and a control interface 50. The housing 10 comprises a first housing portion 11 and a second housing portion 12. The control interface 50 is disposed on the first housing portion 11. The circuit board 20 and the heat-conduction structure 30 are disposed in the housing 10. The circuit board 20 comprises a first electronic device 21, second electronic devices 22 and a substrate 23. The first electronic device 21 and the second electronic devices 22 are disposed on the substrate 23. The heat-conduction structure 30 is disposed on the circuit board 20 and comprises a mounting hole 31. The heat-dissipation structure 40 is a cell phone cover made of metal, particularly copper, and comprises pivot portions 41. The heat-conduction structure 30 and the heat-dissipation structure 40 compose a heat-dissipation module. With reference to Fig. 1b, when the portable electronic apparatus 100 is assembled, the heat-conduction structure 30 is fixed on the circuit board 20. Bolts 42 pass the pivot portions 41 and the housing 10, and are enter mounting holes 31 of the heat-conduction structure 30. The heat-dissipation structure 40 thus pivots on the heat-conduction structure 30. Then, as shown in Fig. 1c, the first housing portion 11 and the second housing portion 12 are assembled.

In the disclosure, electronic devices (for example, chips, resistors, and print circuits) are represented by the first electronic device 21 and the second electronic devices 22 to simplify description.

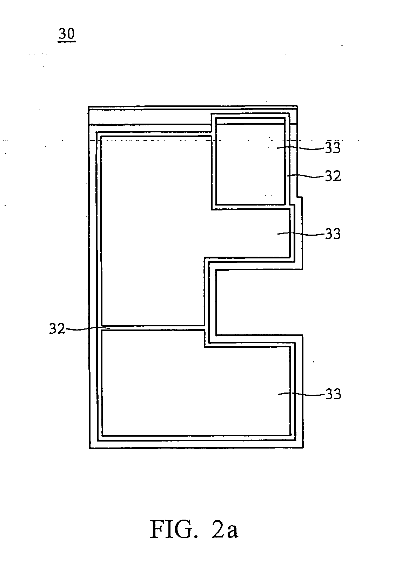

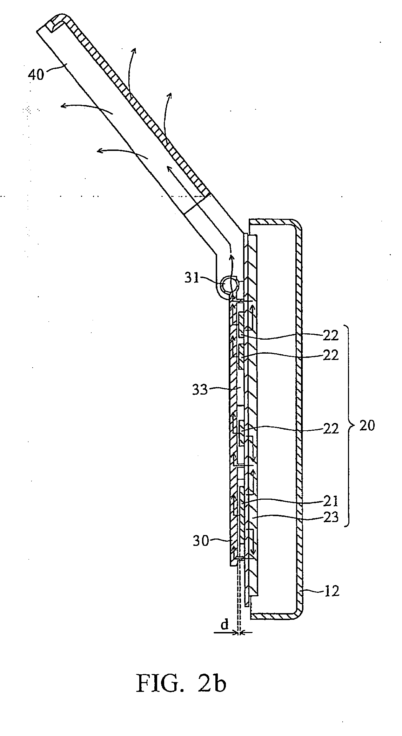

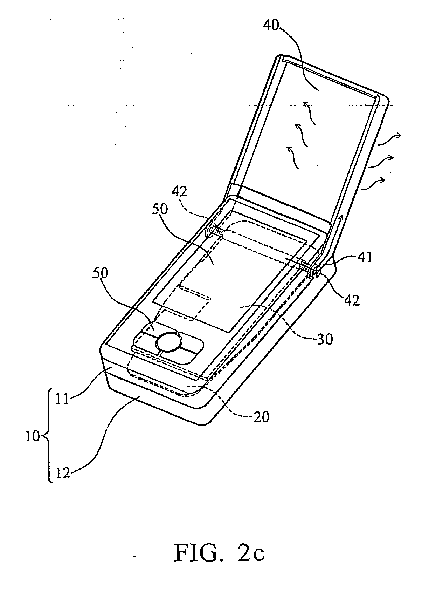

Fig. 2a is a bottom view of the heat-conduction structure 30, which is an isolation cover comprising metal, such as copper. The heat-conduction structure 30 comprises spacers 32 disposed on a surface thereof defining a plurality of isolation regions 33. With reference to Fig. 2b, when the heat-conduction structure 30 is disposed on the circuit board 20, the first electronic device 21 and the second electronic devices 22 are disposed in different isolation regions 33 by the spacer 32. The first electronic device 21 and the second electronic devices 22 keep a gap d from the heat-conduction structure 30. The gap d is between 0.1~0.05mm. Noise between the first electronic device 21 and the second electronic devices 22 is reduced by disposing the first electronic device 21 and the second electronic devices 22 in different isolation regions 33. The heat produced by the first electronic device 21 and the second electronic devices 22 is transmitted to the heat-conduction structure 30 via radiation and conduction (for example, via the air in the isolation regions 33 or via the substrate 23). As shown in Fig. 2c, the heat-dissipation structure 40 pivots on the heat-conduction structure 30 by metal bolts 42. The heat thus passes the heat-conduction structure 30 to the heat-dissipation structure 40 to be dissipated out of the housing 10.

In this embodiment of the invention, the heat-dissipation structure 40 is a cell phone cover, but is not limited thereof. The heat-dissipation structure 40 can be a metal sheet disposed on a surface of the housing 10 or other structure.

The invention reduces inner temperature of the portable electronic apparatus, increases the lifespan of chips and light-emitting elements thereof, and prevents the battery from exploding.

### Second embodiment

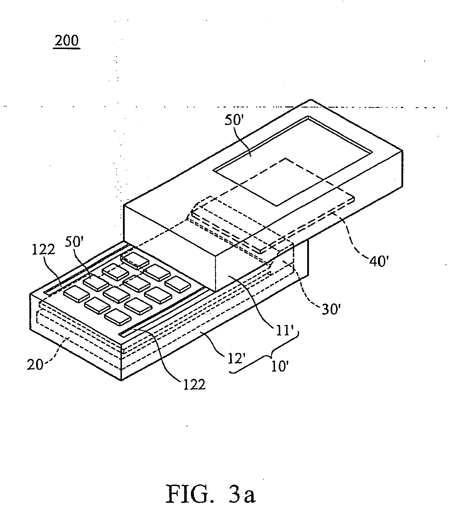

Fig. 3a shows a portable electronic apparatus 200 of a second embodiment of the invention, which is a slide phone comprising a housing 10', a circuit board 20, a heat-conduction structure 30', a heat-dissipation structure 40' and a control interface 50'. The control interface 50' is disposed on the housing 10'. The housing 10' comprises a sliding cover 11' and a body 12'. The body 12' comprises grooves 122 allowing the sliding cover 11' to slide thereon. The circuit board 20 and the heat-conduction structure 30' are disposed in the body 12'. The heat-dissipation structure 40' is a metal sheet disposed on a surface of the sliding cover 11'.

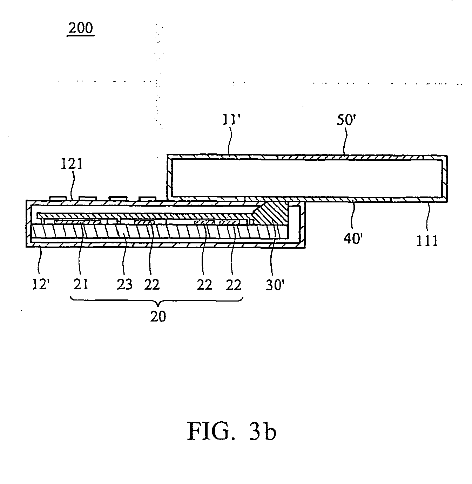

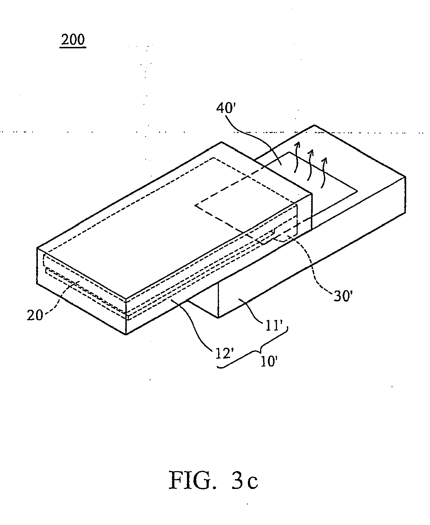

As shown in Fig. 3b, in the second embodiment, the top of the heat-conduction structure 30' is exposed on a first surface 121 of the body 12'. The heat-dissipation structure 40' is disposed on a second surface 111 of the sliding cover 11'. The top of the heat-conduction structure 30' directly contacts the heat-dissipation structure 40'. As shown in Fig. 3c, the heat inside the portable electronic apparatus 200 thus passes the heat-conduction structure 30' to the heat-dissipation structure 40' to be dissipated out of the housing 10.

In this embodiment of the invention, the portable electronic apparatus 200 is a slide phone, but is not limited thereto. The portable electronic apparatus 200 can also be a rotating phone. The heat-dissipation structure 40' is not limited disposition on the cover, and can be disposed on other locations on the portable electronic apparatus 200.

While the invention has been described by way of example and in terms of preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation to encompass all such modifications and similar arrangements.

## Claims

1. A portable electronic apparatus (100), comprising:
a housing (10);
a circuit board (20), disposed in the housing (10) and comprising a substrate (23), a first electronic device (21) and a second electronic device (22), wherein the first electronic device (21) and the second electronic device (22) are disposed on the substrate (23);
a heat-conduction structure (30), detachably disposed on the circuit board (20) in the housing (10) for dissipating a heat from the first electronic device (21), wherein the heat-conduction structure (30) is an electrical isolation cover, and the electrical isolation cover comprises an electrical spacer (32) disposed between the first electronic device (21) and the second electronic device (22) electrically isolating the first electronic device (21) from the second electronic device (22), wherein a material of the heat-conduction structure (30) comprises metal; and
a heat-dissipation structure (40) disposed on the housing (10) and connected to the heat-conduction structure (30) for dissipating the heat out of the housing (10) from the heat-conduction structure (30), **characterized in that** the heat-dissipation structure (40) is a cell phone cover pivoting on the heat-conduction structure (30).

2. The portable electronic apparatus (100) as claimed in claim 1, wherein the heat-conduction structure (30) contacts the substrate (23), and keeps a first gap from the first electronic device (21).

3. The portable electronic apparatus (100) as claimed in claim 2, wherein the heat is transmitted from the first electronic device (21) to the heat-conduction structure (30) via radiation and/or conduction.

4. The portable electronic apparatus (100) as claimed in claim 1, wherein a material of the cell phone cover comprises metal.

5. The portable electronic apparatus (100) as claimed in claim 4, wherein a material of the cell phone cover comprises copper.

6. A portable electronic apparatus (200), comprising:
a housing (10');
a circuit board (20), disposed in the housing (10') and comprising a substrate (23), a first electronic device (21) and a second electronic device (22), wherein the first electronic device (21) and the second electronic device (22) are disposed on the substrate (23) ;
a heat-conduction structure (30'), detachably disposed on the circuit board (20) in the housing (10') for dissipating a heat from the first electronic device (21), wherein the heat-conduction structure (30') is an electrical isolation cover, and the electrical isolation cover comprises an electrical spacer (32) disposed between the first electronic device (21) and the second electronic device (22) electrically isolating the first electronic device (21) from the second electronic device (22), wherein a material of the heat-conduction structure (30') comprises metal; and
a heat-dissipationstructure (40') disposed on the housing (10') and connected to the heat-conduction structure (30') for dissipating the heat out of the housing (10') from the heat-conduction structure (30'), **characterized in that** the housing (10') comprises a sliding cover (11') and a body (12'), the sliding cover (11') is slidably connected to the body (12'), the circuit board (20) and the heat-conduction structure (30') are disposed in the body (12'), and the heat-dissipation structure (40') is disposed on a surface of the sliding cover (11').

7. The portable electronic apparatus (200) as claimed in claim 6, wherein the heat-dissipation structure (40') is a metal sheet.

## Patentansprüche

1. Eine tragbare elektronische Vorrichtung (100), umfassend:
ein Gehäuse (10);
eine Leiterplatte (20), die in dem Gehäuse (10) angeordnet ist und ein Substrat (23), eine erste elektronische Vorrichtung (21) und eine zweite elektronische Vorrichtung (22) umfasst,
wobei die erste elektronische Vorrichtung (21) und die zweite elektronische Vorrichtung (22) auf dem Substrat (23) angeordnet sind;
eine wärmeleitenden Struktur (30), die abnehmbar auf der Leiterplatte (20) in dem Gehäuse (10), zum Ableiten von Wärme von der ersten elektronischen Vorrichtung (21), angeordnet ist, wobei die wärmeleitende Struktur (30) eine elektrischen Isolationsabdeckung ist, und die elektrische Isolationsabdeckung umfasst einen elektrischen Abstandshalter (32), der zwischen der ersten elektronischen Vorrichtung (21) und der zweiten elektronischen Vorrichtung (22) angeordnet ist, und die erste elektronische Vorrichtung (21) von der zweiten elektronischen Vorrichtung (22) elektrisch isoliert, wobei ein Material der wärmeleitenden Struktur (30) Metall umfasst, und
eine wärmeableitende Struktur (40) an dem Gehäuse (10) angeordnet ist und mit der wärmeleitenden Struktur (30) zum Abführen der Wärme aus dem Gehäuse (10) von der wärmeleitenden Struktur (30) verbunden ist, **dadurch gekennzeichnet, dass** die wärmeableitenden Struktur (40) ein Mobiltelefon-Abdeckung ist, die schwenkbar an der wärmeleitenden Struktur (30) ist.

2. Eine tragbare elektronische Vorrichtung (100) nach Anspruch 1, wobei die wärmeleitende Struktur (30) das Substrat (23) berührt, und einen ersten Abstand von der ersten elektronischen Vorrichtung (21) hält.

3. Eine tragbare elektronische Vorrichtung (100) nach Anspruch 2, wobei die Wärme von der elektronischen Vorrichtung (21) an die wärmeleitende Struktur (30) durch Strahlung und/oder Leitung übertragen wird.

4. Eine tragbare elektronische Vorrichtung (100) nach Anspruch 1, wobei das Material der Mobiltelefon-Abdeckung aus Metall besteht.

5. Eine tragbare elektronische Vorrichtung (100) nach Anspruch 4, wobei ein Material der Mobiltelefon-Abdeckung Kupfer umfasst.

6. Eine tragbare elektronische Vorrichtung (200), umfassend:
ein Gehäuse (10');
eine Leiterplatte (20), die in dem Gehäuse (10') angeordnet ist, und die ein Substrat (23) umfasst, eine erste elektronische Vorrichtung (21) und eine zweite elektronische Vorrichtung (22), wobei die erste elektronische Vorrichtung (21) und die zweite elektronische Vorrichtung (22) auf dem Substrat (23) angeordnet ist;
eine wärmeleitende Struktur (30'), die abnehmbar auf der Leiterplatte (20) in dem Gehäuse (10) zum Ableiten von Wärme von der ersten elektronischen Vorrichtung (21) angeordnet ist, wobei die wärmeleitende Struktur (30') eine elektrische Isolationsabdeckung ist, und die elektrische Isolationsabdeckung einen elektrische Abstandshalter (32), der zwischen der ersten elektronischen Vorrichtung (21) und der zweiten elektronischen Einrichtung (22) angeordnet ist, umfasst, wobei ein Material der wärmeleitenden Struktur (30 ') Metall umfasst, und
eine wärmeableitende Struktur (40') die an dem Gehäuse 10 angeordnet ist, und mit der wärmeleitende Struktur (30') zum Ableiten der Wärme aus dem Gehäuse (10') von der wärmeleitenden Struktur (30') verbunden ist, gekenntzeichnet dadurch, dass das Gehäuse (10 ') einen Schiebedeckel (11') und einen Körper (12') umfasst, der Schiebedeckel (11') ist verschiebbar mit dem Körper (12) verbunden, die Leiterplatte (20) und die wärmeleitende Struktur (30') sind in dem Körper (12') angeordnet und die wärmeableitende Struktur (40') ist auf der Oberfläche des Schiebedeckels (11') angeordnet.

7. Eine tragbare elektronische Vorrichtung (200) nach Anspruch 6, wobei die wärmeableitende Struktur (40') ein Metallblech ist.

## Revendications

1. Un appareil électronique portable (100), comprenant:
un logement (10);
un circuit imprimé (20), disposé au sein du logement (10) et comprenant un substrat (23), un premier dispositif électronique (21) et un second dispositif électronique (22), dans lequel le premier dispositif électronique (21) et le second dispositif électronique (22) sont disposés sur le substrat (23);
une structure conductrice de chaleur (30), disposée de manière amovible sur le circuit imprimé (20) au sein du logement (10) pour la dissipation de chaleur depuis le premier dispositif électronique (21), dans laquelle la structure conductrice de chaleur (30) est un couvercle électriquement isolant, et le couvercle électriquement isolant comporte une entretoise électrique (32) disposée entre le premier dispositif électronique (21) et le second dispositif électronique (22) isolant électriquement le premier dispositif électronique (21) du second dispositif électronique (22), dans laquelle un matériau de la structure conductrice de chaleur (30) comporte du métal, et
une structure dissipatrice de chaleur (40) disposée sur le logement (10) et connectée à la structure conductrice de chaleur (30) pour dissiper hors du logement (10) la chaleur de la structure conductrice de chaleur (30), **caractérisé en ce que** la structure dissipatrice de chaleur (40) est un couvercle de téléphone cellulaire pivotant sur la structure conductrice de chaleur (30).

2. L'appareil électronique portable (100) tel que revendiqué dans la revendication 1, dans lequel la structure conductrice de chaleur (30) est en contact avec le substrat (23), et maintient un premier vide avec le premier dispositif électronique (21).

3. L'appareil électronique portable (100) tel que revendiqué dans la revendication 2, dans lequel la chaleur est transmise depuis le premier dispositif électronique (21) vers la structure conductrice de chaleur (30) par radiation et/ou conduction.

4. L'appareil électronique portable (100) tel que revendiqué dans la revendication 1, dans lequel un matériau du couvercle du téléphone cellulaire comporte du métal.

5. L'appareil électronique portable (100) tel que revendiqué dans la revendication 4, dans lequel un matériau du couvercle du téléphone cellulaire comporte du cuivre.

6. Un appareil électronique portable (200), comprenant:
un logement (10');
un circuit imprimé (20), disposé au sein du logement (10') et comprenant un substrat (23), un premier dispositif électronique (21) et un second dispositif électronique (22), dans lequel le premier dispositif électronique (21) et le second dispositif électronique (22) sont disposés sur le substrat (23);
une structure conductrice de chaleur (30'), disposée de manière amovible sur le circuit imprimé (20) au sein du logement (10') pour la dissipation de chaleur depuis le premier dispositif électronique (21), dans laquelle la structure conductrice de chaleur (30') est un couvercle électriquement isolant, et le couvercle électriquement isolant comporte une entretoise électrique (32) disposée entre le premier dispositif électronique (21) et le second dispositif électronique (22) isolant électriquement le premier dispositif électronique (21) du second dispositif électronique (22), dans laquelle un matériau de la structure conductrice de chaleur (30) comporte du métal, et
une structure dissipatrice de chaleur (40') disposée sur le logement (10') et connectée à la structure conductrice de chaleur (30') pour dissiper hors du logement (10') la chaleur de la structure conductrice de chaleur (30'), **caractérisé en ce que** le logement (10') comporte un couvercle coulissant (11') et un corps (12'), le couvercle coulissant (11') étant fixé de manière coulissante au corps (12'), le circuit imprimé (20) et la structure conductrice de chaleur (30') étant disposées dans la corps (12'), et la structure dissipatrice de chaleur (40') étant disposée sur une surface du couvercle coulissant (11').

7. L'appareil électronique portable (200) tel que revendiqué dans la revendication 6, dans lequel la structure dissipatrice de chaleur (40') est une feuille métallique.
